# EUROPEAN PATENT SPECIFICATION

(11) **EP 1 852 920 B1**
(45) Date of publication and mention of the grant of the patent: **06.08.2008**
(21) Application number: 04821380.5
(22) Date of filing: 29.12.2004
(51) Int. Cl.: H01L 31/18, H01L 27/14

(54) **METHOD OF TREATING POLYCRYSTALLINE LEAD SELENIDE INFRARED DETECTORS**
VERFAHREN ZUM BEHANDELN VON POLYKRISTALL-BLEISELENID-INFRAROTDETEKTOREN
PROCEDE DE TRAITEMENT DE DETECTEURS A INFRAROUGE AU SELENIURE DE PLOMB POLYCRISTALLIN

(43) Date of publication of application: 07.11.2007
(73) Proprietor: Ministerio De Defensa, 28071 Madrid (ES)
(72) Inventor: VERGARA OGANDO, Germán, E-28050 Madrid (ES); ALMAZÁN CARNEROS, Rosa, E-28028 Madrid (ES); GOMEZ ZAZO, Luis Jorge, E-28033 Madrid (ES); VERDU HERCE , Marina, E-28020 Madrid (ES); RODRIGUEZ FERNANDEZ, Purificación, E-28031 Madrid (ES); MONTOJO SUPERVIELLE, María Teresa, E-28220 Majadahonda (Madrid) (ES)
(74) Representative: Sanchez del Campo Gonzalez de Ubierna, Ramon
(86) International application number: PCT/ES2004/000586
(87) International publication number: WO 2006/072640

(56) References cited:
- US-A- 3 026 218
- US-A1- 2002 058 352
- TORQUEMADA M.C. ET AL.: 'Role of Halogens in the mechanism of sensitization of uncooled PbSe infrared photodetectors' JOURNAL OF APPLIED PHYSICS vol. 93, no. 3, 2003, pages 1778 - 1784, XP012058987
- HUMPHREY R.L. ET AL.: 'Photoconductivity of Lead Selenide: Theory of the Mechanism of Sensitization' PHYSICAL REVIEW vol. 105, no. 6, 1957, pages 1736 - 1740, XP008084907
- MUNOZ A. ET AL: 'PbSe photodetector arrays for IR sensors' THIN SOLID FILMS vol. 317, 1998 - 1998, AMSTERDAM, pages 425 - 428

## Description

### OBJECT OF THE INVENTION

It is a primary object of the present invention to provide a method to process polycrystalline lead selenide detectors based on thermal evaporation in vacuum followed by an innovative sensitization process consisting on a three folded specific thermal treatment. The method is clearly superior to all previous technologies known to process polycrystalline PbSe two dimensional arrays monolithically integrated with a ROIC, to process x-y addressed two-dimensional arrays and to process multicolor arrays of polycrystalline PbSe detectors. It is still another object of this invention to provide an improved method to process single element polycrystalline lead selenide infrared detectors. It is yet another object of this invention to provide an improved method to process linear arrays of polycrystalline lead selenide infrared detectors. It is still another object of this invention to provide a method to process two-dimensional arrays of polycrystalline lead selenide infrared detectors. It is a further object of this invention to provide a method to process two-dimensional arrays of polycrystalline lead selenide infrared detectors monolithically integrated with a read out integrated circuit (ROIC)

### FIELD OF THE INVENTION

The present invention relates to low cost uncooled infrared detectors, and in particular to a method to process polycrystalline lead selenide infrared detectors (PbSe) comprising substrate preparation, PbSe deposition by thermal evaporation and an innovative three folded thermal treatment for sensitizing PbSe. The method allows to process different type of infrared detectors: single elements, linear arrays, two-dimensional arrays, high density two dimensional arrays monolithically integrated with their read out CMOS (Complementary Metal Oxide Semiconductor) circuitry and detectors processed on interference filters which permits a monolithic integration of spectrally selective uncooled infrared detectors.

### BACKGROUND OF THE INVENTION

Polycrystalline lead selenide is one of the oldest infrared detectors. It is a photonic detector, photoconductor type, sensitive to electromagnetic radiation of wavelengths up to 6 µm. Their most remarkable characteristics are that they present high detectivities at room temperature, they are very fast and sensitive in the medium wavelength IR range (MWIR). These important characteristics are a consequence of the morphological structure consisting in a thin layer, typically 1-2 µm thick, of compacted PbSe microcrystals. Physics involved in the process of photoconductivity is still not well understood but it is widely accepted that oxygen plays a key role and it is necessary to built in a small amount of this element in the PbSe microcrystal lattice.

Standard processing of polycrystalline lead selenide detectors is based on a chemical deposition process which basic reaction is that between selenourea and lead acetate. The addition of oxidizing agents during deposition and subsequent oxidation treatments after film formation are necessary to achieve a high detectivity. This chemical deposition method is labeled as "standard" and, until date, it has been extensively used for all the PbSe detectors manufacturers in the world. For a description of the standard chemical deposition method Mc Lean, US Patent n° 2.997.409 (1961); T.H. Johnson, US Patent n° 3.178.312 (1965) or E.A. Autrey, US Patent n° 3.356.500 (1967.). M.C. Torquemada et al., Journal of Applied Physics, 93,1778-1784(2003) discusses the use of halogens to sensitise PbSe photodetectors. A. Muñoz et. al., Thin Solid Films 317(1998), 425-428 describe photodetectors arrays for IR sensors.

Along the history some groups have used alternative methods for depositing PbSe. Among them, thermal evaporation of lead salts appears as one of the most studied options. So, J.V. Morgan, US patent n° 3.026.218 (1962) describes a method for depositing Lead Sulfide (PbS) by thermal evaporation. This method of deposition was practically abandoned because after numerous experiments it was widely spread the credence that it produced less sensitive detectors, poorer yields and lack of reproducibility.

However and although the chemical deposition has been considered as the most reliable method for processing polycrystalline lead selenide detectors it presents some limitations: 1) it is compatible with a very limited number of substrates; 2) deposition of large polycrystalline clusters, makes necessary to use textured coatings, see N.F. Jacksen, US Patent n° 6.734.516 (2004), which should have good adhesion properties with the substrate used, low thermal expansion coefficient mismatch with lead selenide, good electrical insulation, inertness to high pH chemicals, controlled finish etc.; 3) lack of film thickness uniformity and sensitivity across the wafer and from wafer to wafer. All these, together with the intrinsic difficulties associated to polycrystalline materials are the more important reasons why, at present, there is not any two-dimensional polycrystalline lead selenide array commercialized.

The polycrystalline nature of PbSe has been an important handicap for processing reliable monolithic devices of PbSe. N.F. Jacksen, U.S. patent n° 2002/0058352 A1, reported a method for processing monolithic devices (Focal Plane Arrays) of PbSe. The method described is based on the standard deposition method of PbSe (chemical deposition). The big disadvantage associated to this way to proceed is the necessity of using "textured" substrates in order to avoid problems related with the intrinsically rough polycrystalline layer deposited due to the PbSe crystal sizes. This disadvantage is overcome by a thermal deposition method, because the PbSe big crystals are formed during the sensitization process after deposition the material. The as evaporated layer is constituted of very small crystals adaptable to any type of surface.

### SUMMARY OF THE INVENTION

The method of the present invention is as recited in claim 1 and comprises: 1) substrate selection and preparation consisting in a) depositing of isolating layers, if necessary, b) metal deposition; c) contact delineation using wet or dry etching; 2) Sensor delineation using photolithography and suitable lift off resins; 3) PbSe deposition by thermal evaporation in vacuum 4 Delineation of the active area of detectors by lift off or similar process; 5) Thermal treatments for sensitizing the active material; 6) Deposition of a passivating layer on the active material. Further advantageous embodiments are described in the dependent claims.

The substrate is preferably silicon but other suitable substrates are: Al₂O₃, Sapphire, Germanium, glass, etc. In case of using a semiconductor as substrate (Silicon, Germanium, etc.,) it is necessary to diffuse or to deposit a dielectric layer on its surface in order to prevent leaking currents and to guarantee good electrical isolation between sensors. After substrate selection and surface preparation, a metal layer for contacts is deposited. Pure gold (99,99%) provides the best ohmic contacts with lead selenide. Depending on the type of substrate used and in order to improve gold adherence to the substrate, sometimes it is recommended to deposit between substrate and gold other conducting layers such as Cr, Ti, Ti-W etc. Taking in account the intermetalic diffusion issue and designing proper antidiffusion layers there is not any restriction with the metals used, but the last layer, the metal in direct contact with PbSe must be pure gold. After metal deposition, contact delineation is the next step. It is possible to use several techniques (mechanical masks during metal deposition, photolithographic methods using suitable resins followed by dry or wet etching etc.). There is not any restriction with the contact delineation technique used while metal integrity (element purity, mechanical and electrical characteristics) was kept unmodified. Hereinafter, the piece of material so processed is called patterned substrate (d-substrate). Then, a photolithographic resin is deposit on d-substrate by standard methods. The resin is insolated and developed in such a way that in those places designated for depositing PbSe, the resin is removed by dry or wet etching, leaving these places free of resin. After that a thin layer of PbSe is deposited by thermal evaporation in vacuum. Then, the resin and the PbSe deposited on it are removed by dry or wet etching, staying the PbSe directly bonded to the d-substrate. Hereinafter the piece of material so processed is called insensitive substrate (i-substrate)

In order to turn the i-substrate sensitive to infrared radiation, it is submitted to three consecutive thermal treatments as recited in claim 1. After that the polycrystalline PbSe detectors become sensitive to infrared light. Hereinafter the piece of material so processed will be called detector. Finally and with the objective to protect the detector against environment a thin layer of passivation (Si0₂, Si₃N₄, etc.,) is deposited on the polycrystalline PbSe.

### BRIEF DESCRIPTION OF THE FIGURES

**Figure 1** shows a flowchart 100 illustrating one embodiment of the method to process polycrystalline lead selenide detectors.

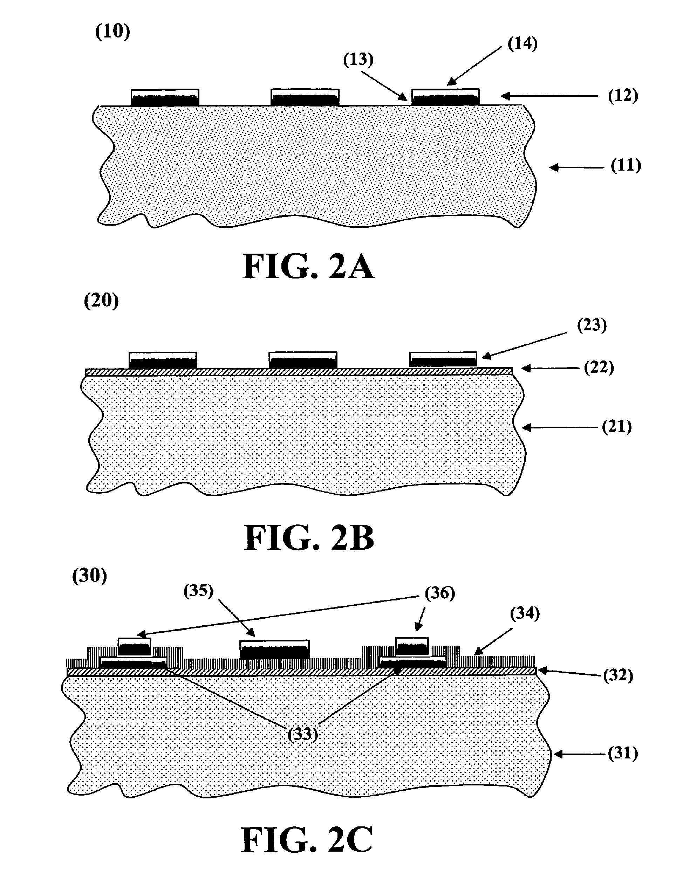

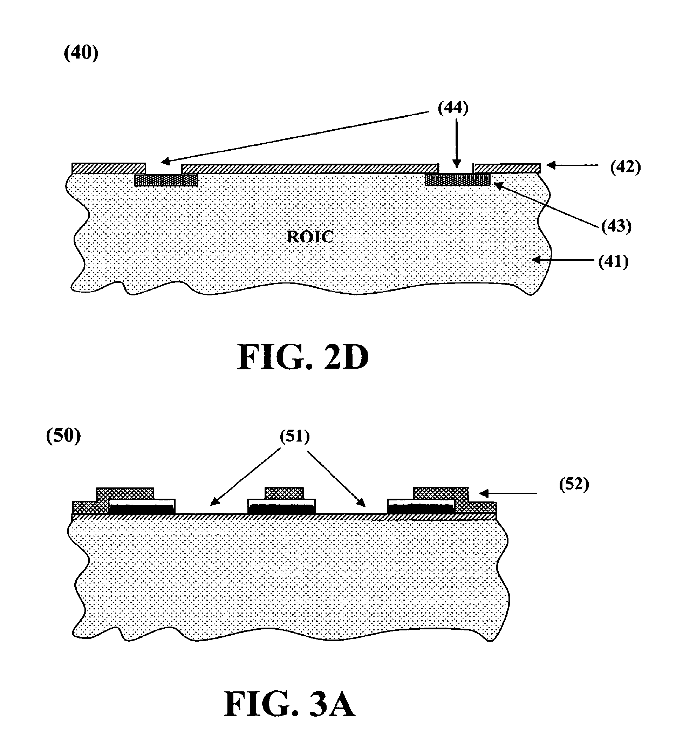

**Figure 2** shows different type of substrates (2A, 2B, 2C and 2D) compatible with the method described to process PbSe. In particular, **figures 2A and 2B** describe substrates that would be appropriated to manufacture single element, multielement, linear arrays or very low density two dimensional arrays; **figure 2C** would correspond to a x-y addressed type device suitable to manufacture medium density two dimensional array (16x16, 32x32 etc. format) with high filling factors and finally **figure 2D** shows a substrate used to process monolithic devices with the PbSe detectors directly processed onto Read Out Integrated Circuit (ROIC) suitable to manufacture high density two dimensional arrays.
   All substrates described above are patterned substrates and hereinafter will be generically called d-substrates.
**Figure 3** shows different steps of the method object of the present invention. **Figure 3A** shows a d-substrate processed and ready for depositing PbSe by thermal evaporation in vacuum on it. **Figure 3B** shows the piece depicted in figure 3A after PbSe thermal deposition in vacuum. **Figure 3C** shows the piece depicted in figure 3B after lifting off the unwanted PbSe deposited. As it, the figure 3C is an insensitive substrate and hereinafter it will be generically called i-substrate.
**Figure 4** shows a flowchart illustrating one embodiment of the three steps sensitization method used for turning the PbSe sensitive to the IR radiation.
**Figure 5** shows a complete detector cross section, after depositing a passivation layer in order to protect the device.

### DETAILED DESCRIPTION OF THE INVENTION

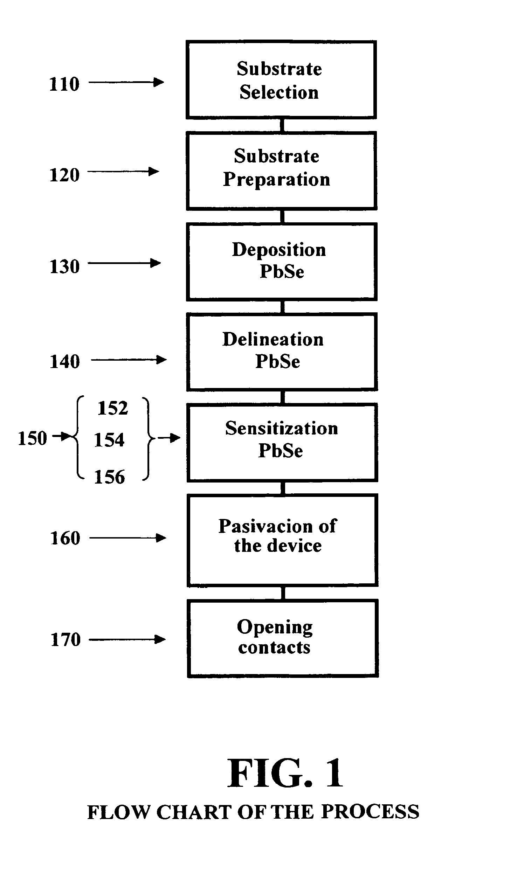

**FIGURE 1** shows a flowchart 100 illustrating one embodiment of the method to process polycrystalline lead selenide detectors. The method begins at step 110 by providing a suitable substrate, depending of the type of device to be processed. The method continues at step 120 depositing, insolating and developing a photolithographic resin, leaving free of resin those places selected for depositing PbSe. The method continues at step 130 depositing a layer of PbSe 1-1,2 µm thick by thermal evaporation in vacuum. The method continues at step 140 removing resin and PbSe (lift off), leaving the substrate with well defined detectors onto its surface. The method continues at step 150 submitting the piece (i-substrate) to a sensitizing treatment. It consists in a three folded thermal treatment: at step 152 the piece (i-substrate) is heating up to 290 °C under an atmosphere of oxygen+ iodine during two hour; after, at step 154, the i-substrate is heating up to 430 °C in air during two hours and finally, at step 156 the piece (i-substrate) is heating up to 240 °C under an atmosphere of oxygen + iodine during 90 minutes. The method continues at step 160 depositing a passivating layer (SiO₂, Si₃N₄, etc.) on the detectors. The method continues at step 170 opening contacts via dry etching.

**FIGURES 2A, 2B, 2C****, and** **2D** show different types of substrates (d-substrates) compatible with the method described.

**FIGURE 2A** shows a patterned substrate (d-substrate) (10) consisting in a piece of dielectric material (sapphire, Al₂O₃, glass, quartz etc.) (11) with metal contacts (12) delineated on it following standard mechanical or photolithographic techniques. Best performance is obtained when the metal used is pure gold 99,99% (14). In case of bad adherence between the substrate chosen and gold, it is possible to use other metals as Cr, Ti, Ti/W, Al etc. (13) in between. The d-substrate material (10) must withstand temperatures as high as 450 °C maintaining unmodified all their electrical, mechanical and functional characteristics.

**FIGURE 2B** shows a patterned substrate (d-substrate) (20) consisting in a piece of semiconductor (21) with a dielectric layer, deposited or diffused onto the semiconductor surface (22) with metal contacts (23) delineated on it following standard mechanical or photolithographic techniques. Best performance is obtained when the metal used is pure gold 99,99% (24). In case of bad adherence between the substrate chosen and the gold, it is possible to use other metals as Cr, Ti, Ti/W, A1 etc. (25) in between. The d-substrate (20) withstands temperatures as high as 450 °C maintaining all their electrical, mechanical and functional characteristics.

**FIGURE 2C** shows a patterned substrate (d-substrate) (30) consisting in a piece of silicon (31) with a thin layer of SiO₂ thermically diffused (32) with metal contacts (33) delineated on it (metal 1), with a dielectric layer of SiO₂ (34) deposited by sputtering, Chemical Vapor Deposition (CVD), Plasma Enhanced Chemical Vapor Deposition (PECVD) or other suitable techique, another metal contacts (35) delineated on the dielectric layer (34) (metal 2) and vias hole filled with metal (36) for contacting metal 1. The d-substrate (30) withstands temperatures as high as 450° C maintaining all their electrical, mechanical and functional characteristics.

The d-substrate described above would correspond to a x-y addressed type device and allows to read each element of an array biasing the corresponding row and column. The embodiment described posses several technical features. With the electrical contact patterns, higher fill factors, over eighty percent, are obtained, which would increase the resolution of the detector.

**FIGURE 2D** shows a patterned substrate (d-substrate) (40) comprising an integrated circuit ROIC (41) with a passivation layer (42) deposited onto its surface by a suitable method, a plurality of electrical contacts (43) coming from the ROIC's last metal layer and an electrical common grid (44). Like the best performance is obtained when the metal in contact with PbSe is pure gold, bad adherence or diffusion problems between the ROIC contacts (45) and gold, can be solved by using other metals as Cr, Ti, Ti/W, A1 etc. (46) in between. The d-substrate (40) withstands temperatures as high as 450 ° C maintaining all their electrical, mechanical and functional characteristics.

The d-substrate described above would correspond to a high density two dimensional array of detectors monolithically integrated with its read out integrated circuitry (ROIC).

**FIGURE 3A** shows a d-substrate as described in, for instance, Figure 2D (50) ready for depositing PbSe by thermal evaporation in vacuum, comprising a ROIC (51), a dielectric layer (52) with via holes filled with metal for contacting (53) with the last metal of the ROIC and a common electrical grid (54). Detectors delineation correspond with those places (55) where the resist (56) has been removed prior PbSe deposition. Photolitographic resist must withstand the 130° C of temperature used during the PbSe thermal evaporation in vacuum process. This d-sustrate is introduced in a standard thermal evaporation system. In order to guarantee uniformity it is recommendable to locate it in a rotating plate. During PbSe deposition, the substrate temperature must be constant, uniform and equal to 120°C. During deposition oxygen must be introduced inside the chamber at a pressure of 1 x 10⁻⁴ mbar.

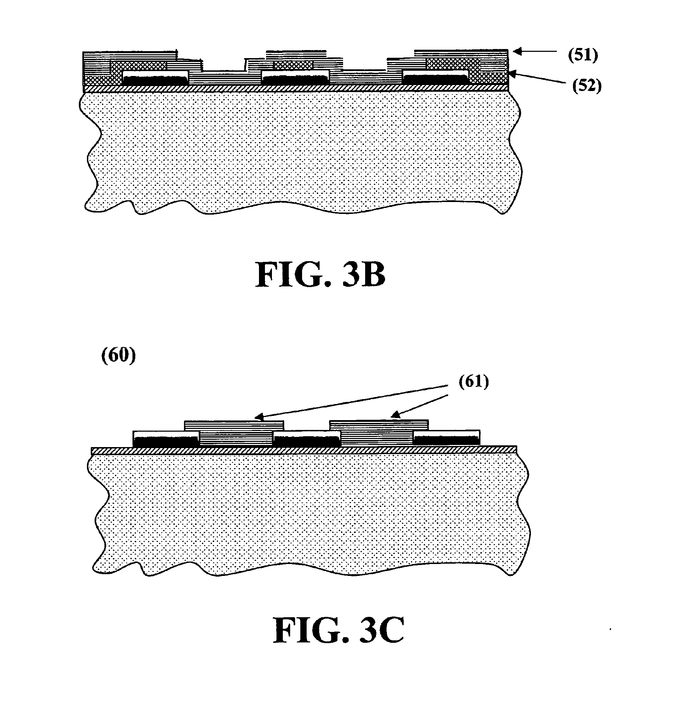

**FIGURE 3B** shows the piece described in figure 3A after PbSe deposition by thermal evaporation on it. Thickness of PbSe layer (57) so deposited ranges between 1 and 1,3 µm. Resist (56) and the PbSe deposited on it are removed by a standard lift off process.

**FIGURE 3C** shows an insensitive substrate (1-substrate) (60) with the insensitive PbSe detectors (61) delineated and ready for being submitted to the specific sensitization process. In certain embodiments, the detector elements (61) may have a relatively small pitch, less than 30 x 30 microns, which allow large format focal plane arrays (FPAs) in the same integrated circuit space.

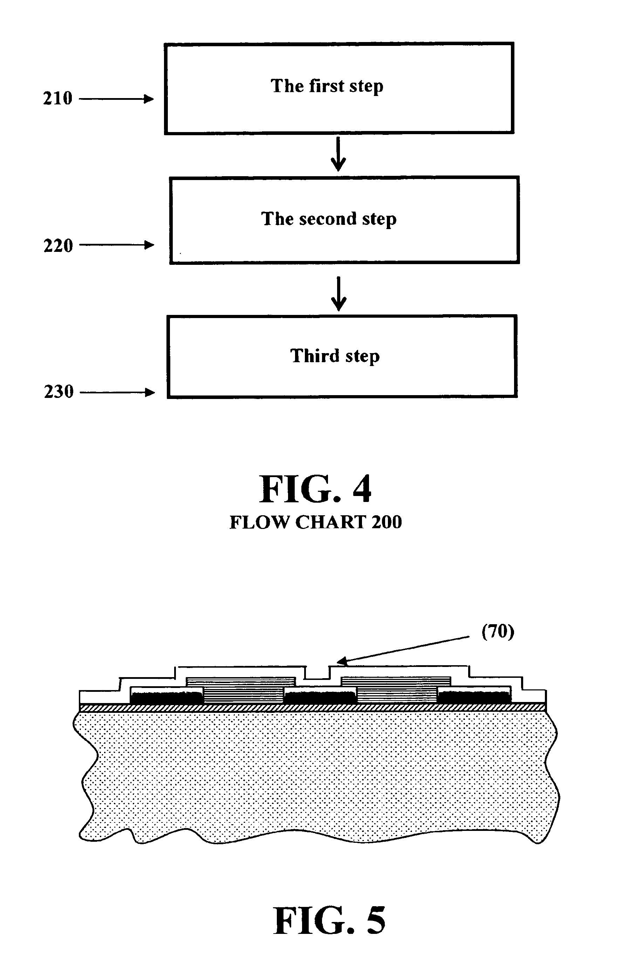

**FIGURE 4** is a flowchart (200) illustrating one embodiment of a method for sensitizing PbSe after depositing by thermal evaporation. The method begins in step 210 by heating the i-substrate up to 290° C in a iodine + oxygen atmosphere during 2 hours. The method continues at step 220 by heating the i-substrate up to 450 °C in air during 120 min. Finally at step 230 the i-substrate is heated at 240° C during 90 min in an iodine+oxygen atmosphere. Once finished the sensitizing method the PbSe detectors are sensible to the infrared radiation ranging between 3 and 5 microns with detectivities ranging between 1-3 x 10⁹ Hz^{1/2}W⁻¹cm for a 500 K black body source.

**FIGURE 5** Finally a passivation layer (70) is deposited onto the device surface. This passivation layer may be deposited using standard methods such as sputtering, PECVD, etc. Contacts must be protected using metal shadow masks or any other appropriate technique.

Although several embodiments (Figures 2A, 2B, 2C and 2D) have been discussed for the present invention, a variety of additions, deletions, substitutions and transformations will be readily suggested to those skilled in the art.

## Claims

1. A method to process polycrystalline lead selenide (PbSe) infrared detectors, the method comprising:
a. Substrate selection and
b. Substrate preparation and
c. Metal deposition and
d. Metal delineation and
e. Sensor delineation and
f. PbSe deposition by thermal evaporation and
g. PbSe sensitization consisting in a specific three step thermal treatment:
i. 290° C during two hours in an oxygen + iodine atmosphere
ii. 430°C during two hours in air
iii. 240°C during one hour and a half in an oxygen + iodine atmosphere.
h. Deposition of a passivating layer on the active material
i. Contact opening

2. The method of claim 1, wherein the substrate comprises dielectric materials such as sapphire, glass, alumina, etc.

3. The method of claim 1, wherein the substrate comprises, a semiconductor such as silicon or germanium, with a dielectric layer diffused or deposited on its surface.

4. The method of claim 1, wherein the substrate comprises a semiconductor such as silicon with a dielectric layer diffused or deposited on it; delineating a first set of electrical contacts upon the dielectric layer; depositing an second dielectric layer; creating vias through this layer to the first set of electrical contacts; delineating a second set of electrical contacts forming electrical couplings with the first contact set.

5. The method of claim 1, wherein the substrate comprises an integrated circuit (ROIC) having a passivation layer covering a plurality of electrical contacts; creating vias through the passivation layer to the electrical contacts and forming electrical couplings between the electrical contacts and a common grid.

6. The method of claim 1, wherein the electrical contacts comprise a diversity of metals (Au, Cr, Al, Ti-W, etc.) but with ultimate limitation that gold (99,99% pure) has to be the last metal deposited for being in contact with the PbSe.

## Patentansprüche

1. Ein Verfahren zur Herstellung von Bleiselenid (PbSe) Infrarotdetektoren, wobei das Verfahren Folgendes umfasst:
a. Auswahl des Trägers und
b. Präparation des Trägers und
c. Ablagerung des Metalls und
d. Abgrenzung des Metalls und
e. Abgrenzung des Sensors und
f. PbSe-Ablagerung mittels Wärmeverdampfung und
g. PbSe-Sensibilisierung, die in einer spezifischen Wärmebehandlung in drei Schritten besteht:
i. 290° C während zwei Stunden in einer Umgebung aus Sauerstoff + Jod
ii. 430° C während zwei Stunden in Luft
iii. 240° C während anderthalb Stunden in einer Umgebung aus Sauerstoff + Jod
h. Ablagerung einer passivierenden Schicht auf dem aktiven Material
i. Öffnen des Kontakts.

2. Das Verfahren nach Anspruch 1, bei welchem der Träger dielektrische Materialien wie zum Beispiel Saphir, Glas, Aluminium, etc. einschließt.

3. Das Verfahren nach Anspruch 1, bei welchem der Träger einen Halbleiter wie zum Beispiel Silizium oder Germanium mit einer auf dessen Oberfläche diffundierten oder abgelagerten dielektrischen Schicht einschließt.

4. Das Verfahren nach Anspruch 1, bei welchem der Träger einen Halbleiter wie zum Beispiel Silizium mit einer auf dessen Oberfläche diffundierten oder abgelagerten dielektrischen Schicht einschließt; wobei ein erster Satz von elektrischen Kontakten auf der dielektrischen Schicht abgegrenzt ist; wobei eine zweite dielektrische Schicht abgelagert wird; wobei Wege durch diese Schicht zu dem ersten Satz von elektrischen Kontakten geschaffen werden; wobei ein zweiter Satz von elektrischen Kontakten abgegrenzt wird, die elektrische Kopplungen mit den ersten Satz Kontakte bilden.

5. Das Verfahren nach Anspruch 1, bei welchem der Träger einen integrierten Schaltkreis (ROIC) umfasst, der eine passivierende Schicht besitzt, die eine Vielzahl von elektrischen Kontakten abdeckt; wobei Wege durch die passivierende Schicht zu den elektrischen Kontakten geschaffen und elektrische Kopplungen zwischen den elektrischen Kontakten und einem gewöhnlichen Netz gebildet werden.

6. Das Verfahren nach Anspruch 1, bei welchem die elektrischen Kontakte eine Vielzahl von Metallen (Au, Cr, Al, Ti-W, etc.) einschließen, jedoch mit der ultimativen Begrenzung, dass Gold (99,99% rein) als letztes Metall abgelagert werden muss, um mit dem PbSe in Kontakt zu stehen.

## Revendications

1. Un procédé pour traiter les détecteurs à infrarouge au séléniure de plomb (PbSe) polycristallin, le procédé comprenant:
a. la sélection du substrat et
b. la préparation du substrat et
c. le dépôt du métal et
d. la délimitation du métal et
e. la délimitation du capteur et
f. le dépôt du PbSe par évaporation thermique et
g. la sensibilisation du PbSe consistant en un traitement thermique spécifique en trois étapes:
i. 290°C durant deux heures dans une atmosphère d'oxygène + iode
ii. 430°C durant deux heures dans l'air
iii. 240°C durant une heure et demie dans une atmosphère d'oxygène + iode
h. le dépôt d'une couche de passivation sur la matière active
i. l'ouverture des contacts

2. Le procédé de la revendication 1, dans lequel le substrat comprend des matériaux diélectriques tels que le saphir, le verre, l'alumine, etc.

3. Le procédé de la revendication 1, dans lequel le substrat comprend un semi-conducteur tel que le silicium ou le germanium, avec une couche diélectrique diffusée ou déposée sur sa surface.

4. Le procédé de la revendication 1, dans lequel le substrat comprend un semi-conducteur tel que le silicium avec une couche diélectrique diffusée ou déposée sur lui; délimitant un premier ensemble de contacts électriques sur la couche diélectrique; déposant une seconde couche diélectrique; créant des trous d'interconnexion à travers cette couche vers le premier ensemble de contacts électrique; délimitant un second ensemble de contacts électriques formant des couplages électriques avec le premier ensemble de contacts.

5. Le procédé de la revendication 1, dans lequel le substrat comprend un circuit intégré (ROIC) possédant une couche de passivation couvrant une pluralité de contacts électriques; créant des trous d'interconnexion à travers la couche de passivation vers les contacts électriques et formant des couplages électriques entre les contacts électriques et une grille ordinaire.

6. Le procédé de la revendication 1, dans lequel les contacts électriques comprennent une diversité de métaux (Au, Cr, Al, Ti-W, etc.) mais avec la limitation ultime que l'or (pur à 99,99%) doit être le dernier métal déposé pour être en contact avec le PbSe.
